# EUROPEAN PATENT APPLICATION

(11) **EP 4 715 879 A1**
(43) Date of publication of application: **25.03.2026**
(21) Application number: 24810153.7
(22) Date of filing: 25.04.2024
(51) Int. Cl.: H01L 33/58

(54) **DISPLAY PANEL AND DISPLAY APPARATUS**

(30) Priority: 19.05.2023 CN 202310572990
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: SHI, Bo, Beijing 100176 (CN); HU, Ming, Beijing 100176 (CN); SONG, Gukhwan, Beijing 100176 (CN); JIANG, Zhiliang, Beijing 100176 (CN); TAN, Yuanhao, Beijing 100176 (CN); FU, Jianji, Beijing 100176 (CN); MOU, Shan, Beijing 100176 (CN); XUE, Xinghao, Beijing 100176 (CN)
(74) Representative: Potter Clarkson
(86) International application number: PCT/CN2024/089868
(87) International publication number: WO 2024/239906

(57) **Abstract**

The present disclosure relates to the technical field of display and relates to a display panel and a display apparatus. The display panel comprises a display substrate (PNL), a light condensing layer (LL) and a light filter layer (CL), the display substrate being provided with a plurality of light emitting devices (LD) distributed in an array. The light condensing layer (LL) is arranged on one side of the display substrate and is provided with a plurality of light transmission holes (LH), each light transmission hole (LH) overlapping one light emitting device (LD), and the light condensing layer (LL) being made of a light transmitting material. The light filter layer (CL) covers the light condensing layer and comprises a plurality of light filtering parts (CF), at least some of the light filtering parts (CF) having different colors. Each light filtering part (CF) fills one light transmission hole (LH), the refractive index of the light filtering parts (CF) being greater than the refractive index of the light condensing layer (LL). The light transmission holes (LH) expand in the direction away from the display substrate (PNL). Front brightness can be increased without an increase in power consumption, and thickness can be reduced.

## Description

### CROSS-REFERENCE TO RELATED APPLICATIONS

The present disclosure claims the priority to the Chinese Patent Application No. 202310572990.5, entitled "DISPLAY PANEL AND DISPLAY APPARATUS", filed on May 19, 2023, the entire contents of which are incorporated herein by reference in their entireties.

### TECHNICAL FIELD

The present disclosure relates to the field of display panel technologies, and specifically, to a display panel and a display apparatus.

### BACKGROUND

Display panels are indispensable components of electronic devices such as mobile phones and computers. The display panels include liquid crystal display panels, organic electroluminescent display panels, etc. Currently, people have increasingly high requirements for display effects, but the brightness of existing display panels, especially the frontal brightness, still needs to be improved. In the prior art, meeting the brightness requirements will result in high power consumption.

It should be noted that the information disclosed in the background section above is only used for enhancement of understanding of the background of the present disclosure, and therefore may include information that does not constitute prior art known to those ordinary skilled in the art.

### SUMMARY

An object of the present disclosure is to overcome the deficiencies in the prior art described above, and provide a display panel and a display apparatus that can enhance the frontal brightness without increasing the power consumption, and reduce the thickness.

According to an aspect of the present disclosure, there is provided a display panel, including:
a display substrate, provided with a plurality of light-emitting devices distributed in an array;
a light-converging layer, arranged at a side of the display substrate, and provided with a plurality of light-transmitting holes, where one light-transmitting hole is overlapped with one light-emitting device, and the light-converging layer is made of a light-transmitting material; and
a light-filtering layer, covering the light-converging layer, and including a plurality of light-filtering parts, where at least some of the light-filtering parts have different colors; one light-filtering part fills one light-transmitting hole; the light-filtering part has a greater refractive index than the light-converging layer; and the light-transmitting hole expands in a direction away from the display substrate.

In an exemplary embodiment of the present disclosure, the display panel further includes:
a light-absorbing layer, arranged at a same side of the display substrate as the light-emitting device; where the light-absorbing layer is overlapped with the light-converging layer, and is at most partially overlapped with the light-transmitting hole.

In an exemplary embodiment of the present disclosure, the light-emitting devices include a first light-emitting device, a second light-emitting device and a third light-emitting device that have different emission colors from each other;
a light-transmitting hole overlapped with the first light-emitting device is a first light-transmitting hole, and a light-filtering part filling the first light-transmitting hole is a first light-filtering part; a light-transmitting hole overlapped with the second light-emitting device is a second light-transmitting hole, and a light-filtering part filling the second light-transmitting hole is a second light-filtering part; and a light-transmitting hole overlapped with the third light-emitting device is a third light-transmitting hole, and a light-filtering part filling the third light-transmitting hole is a third light-filtering part; and
the first light-filtering part has a smaller thickness than the second light-filtering part and the third light-filtering part.

In an exemplary embodiment of the present disclosure, the first light-filtering part has a greater refractive index than the third light-filtering part, and the third light-filtering part has a greater refractive index than the second light-filtering part.

In an exemplary embodiment of the present disclosure, an emission color of the first light-emitting device is red, an emission color of the second light-emitting device is green, and an emission color of the third light-emitting device is blue; and
a color of the first light-filtering part is red, a color of the second light-filtering part is green, and a color of the third light-filtering part is blue.

In an exemplary embodiment of the present disclosure, an orthographic projection of the light-absorbing layer on the display substrate is located within an orthographic projection of the light-converging layer on the display substrate, and is located outside an orthographic projection of the light-transmitting hole on the display substrate.

In an exemplary embodiment of the present disclosure, the light-converging layer is at least partially arranged on a surface of the light-absorbing layer away from the display substrate.

In an exemplary embodiment of the present disclosure, the light-filtering layer has a greater thickness than the light-converging layer; and the light-absorbing layer is arranged on a surface of the light-filtering layer away from the display substrate.

In an exemplary embodiment of the present disclosure, a light-absorbing groove recessed towards the display substrate is provided on a surface of the light-converging layer away from the display substrate, and the light-absorbing layer is filled in the light-absorbing groove.

In an exemplary embodiment of the present disclosure, a number of the light-absorbing groove is more than one, and the light-absorbing groove is an annular structure; one light-absorbing groove surrounds one light-transmitting hole; and light-absorbing grooves surrounding two adjacent light-transmitting holes share a partial region.

In an exemplary embodiment of the present disclosure, the light-converging layer includes a plurality of light-converging islands arranged at intervals, and one light-converging island is provided with one light-transmitting hole.

In an exemplary embodiment of the present disclosure, the light-absorbing layer and the light-converging layer are arranged on a same surface of the display substrate, and the light-converging islands are separated by the light-absorbing layer.

In an exemplary embodiment of the present disclosure, the light-absorbing layer and a portion of the light-converging islands are arranged on a same surface of the display substrate, and a portion of the light-converging islands is arranged on a surface of the light-absorbing layer away from the display substrate.

In an exemplary embodiment of the present disclosure, a light-converging island provided with the first light-transmitting hole is a first light-converging island; a light-converging island provided with the second light-transmitting hole is a second light-converging island; and a light-converging island provided with the third light-transmitting hole is a third light-converging island; and
the first light-converging island and the light-absorbing layer are arranged on a same surface of the display substrate; and the second light-converging island and the third light-converging island are arranged on a surface of the light-absorbing layer away from the display substrate.

In an exemplary embodiment of the present disclosure, a thickness of a region where the light-absorbing layer is overlapped with the second light-converging island is greater than a thickness of a region where the light-absorbing layer is overlapped with the third light-converging island.

In an exemplary embodiment of the present disclosure, the thickness of the region where the light-absorbing layer is overlapped with the second light-converging island is not smaller than 1.5 µm, and not greater than 2 µm; and
the thickness of the region where the light-absorbing layer is overlapped with the third light-converging island is not smaller than 1 µm, and not greater than 1.5 µm.

In an exemplary embodiment of the present disclosure, a boundary of the light-transmitting hole is located outside a boundary of the light-emitting device overlapped with the light-transmitting hole; and a distance, in a direction parallel to the display substrate, between the boundary of the light-transmitting hole and the boundary of the light-emitting device overlapped with the light-transmitting hole is an outward expansion distance of the light-transmitting hole; and
the first light-transmitting hole has a greater outward expansion distance than the third light-transmitting hole, and the third light-transmitting hole has a greater outward expansion distance than the second light-transmitting hole.

In an exemplary embodiment of the present disclosure, the outward expansion distance of the first light-transmitting hole is not smaller than 2.5 µm, and not greater than 3.5 µm;
an outward expansion distance of the second light-transmitting hole is greater than 0, and not greater than 1 µm; and
the outward expansion distance of the third light-transmitting hole is not smaller than 1 µm, and not greater than 2 µm.

In an exemplary embodiment of the present disclosure, the thickness of the first light-filtering part is not smaller than 2.5 µm, and not greater than 3.5 µm; and
a thickness of the second light-filtering part and a thickness of the third light-filtering part are not smaller than 3.4 µm, and not greater than 4 µm.

In an exemplary embodiment of the present disclosure, the display substrate includes:
a driving backplane, where the light-emitting device is arranged at a side of the driving backplane;
an encapsulation layer, covering the light-emitting device; where the light-converging layer and the light-absorbing layer are arranged at a side of the encapsulation layer away from the driving backplane; and
a light-transmitting planarization layer, covering the light-filtering layer, where the light-transmitting planarization layer has a smaller refractive index than the light-filtering layer.

According to an aspect of the present disclosure, there is provided a display apparatus, including the display panel described in any of the above.

In the display panel and the display apparatus of the present disclosure, at least a portion of the light emitted by the light-emitting device can enter the light-filtering part. Due to the light-filtering part having a greater refractive index than the light-converging layer, some light with large divergence angles can undergo total reflection at the interface where the light-filtering part contacts the side wall of the light-transmitting hole, and exit from the light-filtering part, which reduces the divergence angle of the light. This can improve the frontal brightness without increasing the power consumption, or alternatively, maintains the frontal brightness while reducing the power consumption.

Additionally, if the light-emitting devices include light-emitting devices having a plurality of emission colors, the light-filtering part can reduce, through its light-filtering function, external light entering the interior of the display panel, thereby reducing reflection of ambient light. If the light-emitting devices have the same emission color, the light-filtering part can not only reduce reflection of ambient light, but also achieve color display.

Furthermore, since the light-filtering part fills the light-transmitting hole of the light-converging layer, there is an overlap between the light-filtering part and the light-converging layer in the thickness direction, which is beneficial for reducing the thickness while ensuring the above effects.

It should be understood that the above general description and the subsequent detailed description are only exemplary and explanatory, and cannot limit the present disclosure.

### BRIEF DESCRIPTION OF THE DRAWINGS

The accompanying drawings herein are incorporated into the specification and form a part of the specification, illustrate embodiments in accordance with the present disclosure, and are used together with the specification to explain the principles of the present disclosure. It is apparent that the accompanying drawings in the following description are only some embodiments of the present disclosure, and for those ordinary skilled in the art, other accompanying drawings can be obtained based on these accompanying drawings without creative labor.
FIG. 1 is a schematic diagram of a display panel in a first embodiment of the present disclosure.
FIG. 2 is a top view of the light-transmitting hole, the pixel opening and the light-absorbing layer in FIG. 1.
FIG. 3 is a schematic diagram of a display panel in a second embodiment of the present disclosure.
FIG. 4 is a schematic diagram of a display panel in a third embodiment of the present disclosure.
FIG. 5 is a schematic diagram of a display panel in a fourth embodiment of the present disclosure.
FIG. 6 is a top view of the light-transmitting hole, the pixel opening and the light-absorbing layer in FIG. 5.
FIG. 7 is a schematic diagram of a display panel in a solution of a fifth embodiment of the present disclosure.
FIG. 8 is a schematic diagram of a display panel in another solution of the fifth embodiment of the present disclosure.
FIG. 9 is a top view of the light-transmitting hole, the pixel opening and the light-absorbing layer in FIG. 7.
FIG. 10 is a schematic diagram of a display panel in a sixth embodiment of the present disclosure.
FIG. 11 is a schematic diagram of a display panel in a seventh embodiment of the present disclosure.
FIG. 12 is a schematic diagram of a display panel without formation of a light-filtering layer in the seventh embodiment of the present disclosure.

### DETAILED DESCRIPTION

Exemplary embodiments are now described more comprehensively with reference to the accompanying drawings. However, the exemplary embodiments are capable of being implemented in a variety of forms and should not be construed as being limited to the embodiments set forth herein. Rather, the provision of these embodiments allows for the present disclosure to be comprehensive and complete, and conveys the idea of the exemplary embodiments in a comprehensive manner to those skilled in the art. The same reference numerals in the drawings indicate the same or similar structures, and therefore their detailed descriptions will be omitted. In addition, the accompanying drawings are only schematic illustrations of the present disclosure, and are not necessarily drawn to scale.

The terms "a", "an", "the", "said", and "at least one" are used for indicating an existence of one or more elements/components/etc.; and the terms "include" and "have" are used for indicating an open-ended inclusion and mean that there may be additional elements/components/etc. in addition to the listed elements/components/etc. The terms "first", "second" and "third", etc. are used merely as markers, but not as quantitative limitations to the objects thereof.

The "overlap" between A and B in this article refers to the presence of overlapping regions in orthographic projections of A and B on the display substrate, the driving backplane, or the substrate.

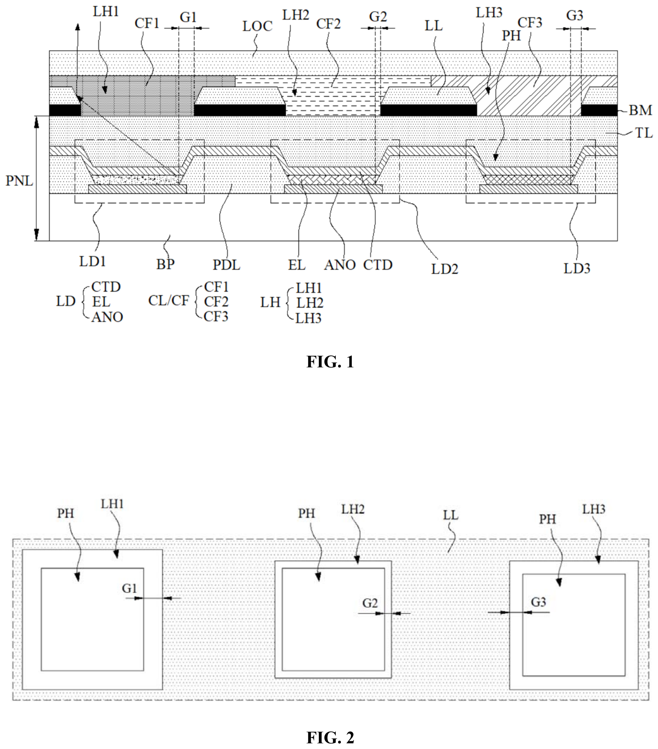

The embodiments of the present disclosure provide a display panel. As shown in FIGS. 1-8, the display panel may include a display substrate PNL, a light-converging layer LL, and a light-filtering layer CL.

The display substrate PNL is provided with a plurality of light-emitting devices LD distributed in an array. The light-converging layer LL is arranged at a side of the display substrate PNL, and provided with a plurality of light-transmitting holes LH. One light-transmitting hole LH is overlapped with one light-emitting device LD. The light-converging layer LL is made of a light-transmitting material.

The light-filtering layer CL covers the light-converging layer LL, and includes a plurality of light-filtering parts CF. One light-filtering part CF fills one light-transmitting hole LH. The light-filtering part CF has a greater refractive index than the light-converging layer LL. The light-transmitting hole LH expands in a direction away from the display substrate PNL.

In the display panel of the embodiments of the present disclosure, at least a portion of the light emitted by the light-emitting device LD can enter the light-filtering part CF. Due to the light-filtering part CF having a greater refractive index than the light-converging layer LL, some light with large divergence angles can undergo total reflection at the interface where the light-filtering part CF contacts the side wall of the light-transmitting hole LH, and exit from the light-filtering part CF, which reduces the divergence angle of the light. This can improve the frontal brightness without increasing the power consumption, or alternatively, maintains the frontal brightness while reducing the power consumption.

Additionally, if the light-emitting devices LD include light-emitting devices LD having a plurality of emission colors, the light-filtering part CF can reduce, through its light-filtering function, external light entering the interior of the display panel, thereby reducing reflection of ambient light. If the light-emitting devices LD have the same emission color, the light-filtering part CF can not only reduce reflection of ambient light, but also achieve color display.

Furthermore, since the light-filtering part CF fills the light-transmitting hole LH of the light-converging layer LL, there is an overlap between the light-filtering part CF and the light-converging layer LL in the thickness direction, which is beneficial for reducing the thickness while ensuring the above effects.

The following provides a detailed description for various components of the display panel in the present disclosure.

The light-emitting device LD of the display substrate PNL may be an organic light-emitting diode (OLED) that uses an organic luminescent material, or may be a light-emitting diode (LED) that uses an inorganic luminescent material, such as a Micro LED (micro light-emitting diode) and a Mini LED (sub-millimeter light-emitting diode). The light-emitting device LD may also be a device such as a QLED (quantum dot diode).

As shown in FIGS. 1-10, the display substrate PNL may include a driving backplane BP, the light-emitting device LD, and an encapsulation layer TL.

The driving backplane BP is provided with a driving circuit that can drive the light-emitting device LD to emit light for image display. The driving backplane BP may include a substrate and a circuit layer located at a side of the substrate. The substrate may be a flat panel structure. The material of the substrate may be a hard material such as glass, or a soft material such as polyimide. Additionally, the substrate may be a single-layer structure or a multi-layer structure.

The circuit layer may be arranged at a side of the substrate, and may include a driving circuit that can drive the light-emitting device LD to emit light. For example, the display panel may be at least divided into a display region and a peripheral region located outside the display region. Correspondingly, the driving circuit may include a pixel circuit located in the display region, and a peripheral circuit located in the peripheral region. The pixel circuit may be a pixel circuit such as 7T1C, 3T1C, etc., as long as it can drive the light-emitting device LD to emit light, and its structure is not specifically limited herein. In some embodiments, nTmC represents a pixel circuit including n transistors (represented by the letter "T") and m capacitors (represented by the letter "C"). The number of pixel circuits is the same as the number of light-emitting devices LD, and the pixel circuits are connected to the light-emitting devices LD in one-to-one correspondence, so as to control the light emission of the light-emitting devices LD separately. Of course, the same pixel circuit may also be connected to more than one light-emitting devices LD, and drive more than one light-emitting devices LD to emit light simultaneously, and no special limitations are made herein.

The peripheral circuit may be located in the peripheral region. The peripheral circuit is connected to the pixel circuit, and is configured to input a driving signal to the pixel circuit to control the light-emitting device LD to emit light. The peripheral circuit may include a gate driving circuit and a light emission control circuit, and of course, may also include other circuits. The specific structure of the peripheral circuit is not specifically limited herein.

The above circuit layer may include a plurality of thin film transistors and capacitors. In some embodiments, the thin film transistor may be a top gate type thin film transistor or a bottom gate type thin film transistor. Each thin film transistor may include an active layer and a gate. The active layers of the thin film transistors are arranged in a same layer, and are arranged in a same semiconductor layer; and the gates of the thin film transistors are arranged in a same layer, and are arranged in a same gate layer, which facilities simplifying of the process. Additionally, the thin film transistors and the capacitors may be arranged at a side of the substrate. The display substrate PNL may further include a planarization layer located at a side of the thin film transistors away from the substrate.

As shown in FIGS. 1-10, the light-emitting devices LD may be arranged on a side surface of the driving backplane BP. For example, the light-emitting devices LD are arranged on a surface of the planarization layer away from the substrate. The light-emitting device LD may include a first electrode ANO, a second electrode CTD, and a luminescent layer EL located between the first electrode ANO and the second electrode CTD. The first electrode ANO, the luminescent layer EL, and the second electrode CTD may be sequentially stacked in a direction away from the driving backplane BP. The pixel circuit applies an electrical signal to the first electrode ANO, the peripheral circuit applies an electrical signal to the second electrode CTD, and in this way, the light-emitting device LD can be excited to emit light.

As shown in FIGS. 1-10, in order to limit the range of the light-emitting device LD, the display substrate PNL may further include a pixel definition layer PDL. The pixel definition layer PDL may be arranged on a same surface of the driving backplane BP as the light-emitting device LD. Additionally, the first electrodes ANO of the light-emitting devices LD are arranged at intervals. The pixel definition layer PDL is provided with pixel openings PH that expose the first electrodes ANO, that is, one pixel opening PH exposes one first electrode ANO. The range of one pixel opening PH is the range of one light-emitting device LD. The shape of the pixel opening PH may be a polygon such as a rectangle, a pentagon, a hexagon, etc., or may be an ellipse, a sector, or other shapes. The shape of the pixel opening is not specifically limited herein.

Furthermore, the pixel opening PH may expand in the direction away from the driving backplane BP, causing that the side edge of the pixel opening PH is a slope surface that expands in the direction away from the driving backplane BP. In an embodiment of the present disclosure, the range of the light-emitting device LD may be defined as the range of the boundary of one end of the pixel opening PH close to the driving backplane BP, that is, the range of the bottom of the pixel opening PH. Of course, the range of the light-emitting device LD may also be defined as the range of the boundary of one end of the pixel opening PH away from the driving backplane BP, that is, the range of the top of the pixel opening PH.

The luminescent layer EL is at least partially located in the pixel opening PH. The luminescent layer EL and the first electrode ANO are arranged in a stacking manner. In some embodiments, the luminescent layer EL may include a hole injection layer, a hole transport layer, a luminescent material layer, an electron transport layer, and an electron injection layer that are stacked sequentially in the direction away from the driving backplane BP. Of course, other structures may also be used, as long as the luminescent layer EL can cooperate with the first electrode ANO and the second electrode CTD to emit light.

As shown in FIGS. 1-10, in some embodiments, the luminescent layers EL of the light-emitting devices LD may be independent from each other and distributed in an array, allowing different light-emitting devices LD to emit different monochromatic light. Of course, in other embodiments, the light-emitting devices LD may share a same luminescent layer EL, that is, the luminescent layer EL is a continuous layer structure, and is stacked with the first electrode ANO in the pixel opening PH. Since the luminescent layer EL is the actual part of the light-emitting device LD that emits light, the range of the light-emitting device LD may also be defined as the range of the portion of the luminescent layer EL where the luminescent layer EL is stacked with the first electrode ANO.

The second electrode CTD may cover the luminescent layer EL, and the second electrode CTD may be a continuous layer structure, allowing the light-emitting devices LD to share the same second electrode CTD.

The first electrode ANO may be the anode of the light-emitting device LD, and the second electrode CTD may be the cathode of the light-emitting device LD. The first electrode ANO may adopt a single-layer reflective structure or a multi-layer reflective structure, and the second electrode CTD may adopt a light-transmitting structure, allowing the light-emitting device LD to emit light in the direction away from the driving backplane BP.

In some embodiments of the present disclosure, the display panel may include a plurality of pixels. Each pixel includes a plurality of sub-pixels. One sub-pixel may include one light-emitting device LD. The luminescent layers EL of the light-emitting devices LD are independently arranged. As shown in FIGS. 1-10, the light-emitting devices LD include a plurality of light-emitting devices LD that have different emission colors from each other, which may include a first light-emitting device LD1, a second light-emitting device LD2, and a third light-emitting device LD3. One pixel may include one first light-emitting device LD1, one second light-emitting device LD2, and one third light-emitting device LD3. For example, an emission color of the first light-emitting device LD1 may be red, an emission color of the second light-emitting device LD2 may be green, and an emission color of the third light-emitting device LD3 may be blue.

As shown in FIGS. 1-10, the encapsulation layer TL may cover the light-emitting devices LD to block external water and oxygen, preventing the external water and oxygen from corroding the light-emitting devices LD. For example, the encapsulation layer TL may adopt a thin film encapsulation manner, and may include a first inorganic layer, an organic layer, and a second inorganic layer.

The first inorganic layer may cover the light-emitting devices LD, that is, the first inorganic layer may cover a surface of the second electrode CTD away from the driving backplane BP. The material of the first inorganic layer may include an inorganic insulating material such as silicon nitride, and silicon oxide.

The organic layer may be arranged on a surface of the first inorganic layer away from the driving backplane BP1. The boundary of the organic layer may be limited to the inner side of the boundary of the first inorganic layer by a barrier dam or other structure located in the peripheral region. Additionally, the boundary of an orthographic projection of the organic layer on the driving backplane BP may be located in the peripheral region, ensuring that the organic layer can cover the light-emitting devices LD.

The second inorganic layer may cover the organic layer and the first inorganic layer that is not covered by the organic layer. The second inorganic layer can block the invasion of water and oxygen. Planarization is achieved through the organic layer that has fluidity before curing. The material of the second inorganic layer may include an inorganic insulating material such as silicon nitride, and silicon oxide.

As shown in FIGS. 1-10, the light-converging layer LL may be arranged at a side of the display substrate PNL, that is, at a side of the encapsulation layer TL away from the driving backplane BP. The light-converging layer LL may be directly arranged on a surface of the encapsulation layer TL away from the driving backplane BP, or there may be a certain distance between the light-converging layer LL and the encapsulation layer TL. The light-converging layer LL is made of a light-transmitting material, and is provided with a plurality of light-transmitting holes LH. One light-transmitting hole LH is overlapped with one light-emitting device LD, that is, orthographic projections of one light-transmitting hole LH and one light-emitting device LD on the driving backplane BP are at least partially overlapped with each other. Furthermore, the number of the light-transmitting holes LH may be the same as the number of the light-emitting devices LD, and the light-transmitting holes LH and the light-emitting devices LD are overlapped in one-to-one correspondence. Of course, the number of the light-transmitting holes LH may also be less than the number of the light-emitting devices LD, and only a portion of the light-emitting devices LD is overlapped with the light-transmitting holes LH. The light-transmitting hole LH expands in a direction away from the display substrate PNL, that is, the area of the cross section (along the section parallel to the display substrate PNL) of the light-transmitting hole LH is gradually increased in the direction away from the display substrate PNL, causing that the side wall of the light-transmitting hole LH is a slope surface that expands in the direction away from the display substrate PNL. For example, the orthographic projection of the light-transmitting hole LH on the display substrate PNL is a circle, and the diameter of the circle is gradually increased in the direction away from the display substrate PNL. Alternatively, the orthographic projection of the light-transmitting hole LH on the display substrate PNL is a rectangle, and at least the distance between two opposing side walls is gradually increased in the direction away from the display substrate PNL.

As shown in FIGS. 1-10, in some embodiments of the present disclosure, a light-transmitting hole LH overlapped with the first light-emitting device LD1 is a first light-transmitting hole LH1, and a light-transmitting hole LH overlapped with the second light-emitting device LD2 is a second light-transmitting hole LH2, and a light-transmitting hole LH overlapped with the third light-emitting device LD3 is a third light-transmitting hole LH3.

The light-filtering layer CL may cover the light-converging layer LL. The light-filtering layer CL may include a plurality of light-filtering parts CF. One light-filtering part CF fills one light-transmitting hole LH, allowing that one light-filtering part CF is overlapped with one light-emitting device LD. If there are light-emitting devices LD having different emission colors, the color of the light-filtering part CF (the color of the light transmitted through the light-filtering part CF) is the same as the emission color of the light-emitting device LD overlapped with the light-filtering part CF, ensuring that the light can be emitted. Correspondingly, there may be light-filtering parts CF having a plurality of colors in the light-filtering parts CF, for example, a light-filtering part CF filling the first light-transmitting hole LH1 is a first light-filtering part CF1, a light-filtering part CF filling the second light-transmitting hole LH2 is a second light-filtering part CF2, and a light-filtering part CF filling the third light-transmitting hole LH3 is a third light-filtering part CF3. The first light-filtering part CF1 may be red, the second light-filtering part CF2 may be green, and the third light-filtering part CF3 may be blue.

As shown in FIGS. 1-10, the light-filtering part CF has a greater refractive index than the light-converging layer LL, causing some light emitted by the light-emitting device LD to undergo total reflection at the interface where the light-filtering part CF contacts the side wall of the light-transmitting hole LH that is filled by the light-filtering part CF, thereby reducing the divergence angle and improving the frontal brightness.

As shown in FIGS. 1-10, in order to fully utilize the side wall of the light-transmitting hole LH, the light-filtering layer CL may have a greater thickness than the light-converging layer LL, that is, the thickness of any light-filtering part CF is greater than the thickness of the light-converging layer LL, causing that the light-transmitting hole LH is fully filled and there is no region on the side wall of the light-transmitting hole LH that is not in contact with the light-filtering part CF. Additionally, the light-filtering layer CL may extend to the surface of the light-converging layer LL away from the display substrate PNL, and adjacent two light-filtering parts CF may extend to the surface of the light-converging layer LL away from the driving backplane BP and are connected with each other. Of course, adjacent two light-filtering parts CF may extend to the surface of the light-converging layer LL away from the driving backplane BP, and the extended portions of the light-filtering parts CF on the surface of the light-converging layer LL away from the driving backplane BP may be stacked in the direction away from the driving backplane BP.

In some embodiments of the present disclosure, the wavelength of the light transmitted through the first light-filtering part CF1 is greater than the wavelength of the light transmitted through the second light-filtering part CF2 and the wavelength of the light transmitted through the third light-filtering part, and the wavelength of the light transmitted through the second light-filtering part CF2 is greater than the wavelength of the light transmitted through the third light-filtering part. Additionally, the first light-filtering part CF1 has a greater refractive index than the third light-filtering part CF3, and the third light-filtering part CF3 has a greater refractive index than the second light-filtering part CF2.

In an embodiment, the first light-filtering part CF1 is red, and may have a refractive index of 1.71. The second light-filtering part CF2 is green, and may have a refractive index of 1.6. The third light-filtering part CF3 is blue, and may have a refractive index of 1.65. Additionally, the light-converging layer LL does not have a light-filtering effect, and can transmit white light. The refractive index of the light-converging layer LL may be 1.47, and is smaller than the refractive index of any light-filtering part CF.

It should be noted that the refractive index of the light-filtering part CF is the refractive index for the light transmitted through the light-filtering part CF. The wavelength of the light transmitted through the light-filtering part CF is within a wavelength range. The wavelength referred to by the refractive index described above is the middle value of this wavelength range or a specified wavelength, which may be used as the main wavelength of the light transmitted through the light-filtering part CF.

The material of the light-filtering part CF may include resin and pigment, etc. The saturation of the light transmitted through different colors of the light-filtering parts CF varies. In order to improve uniformity in dark states, the thickness of a portion of the light-filtering parts CF with higher saturation may be made smaller than the thickness of the light-filtering part CF with lower saturation.

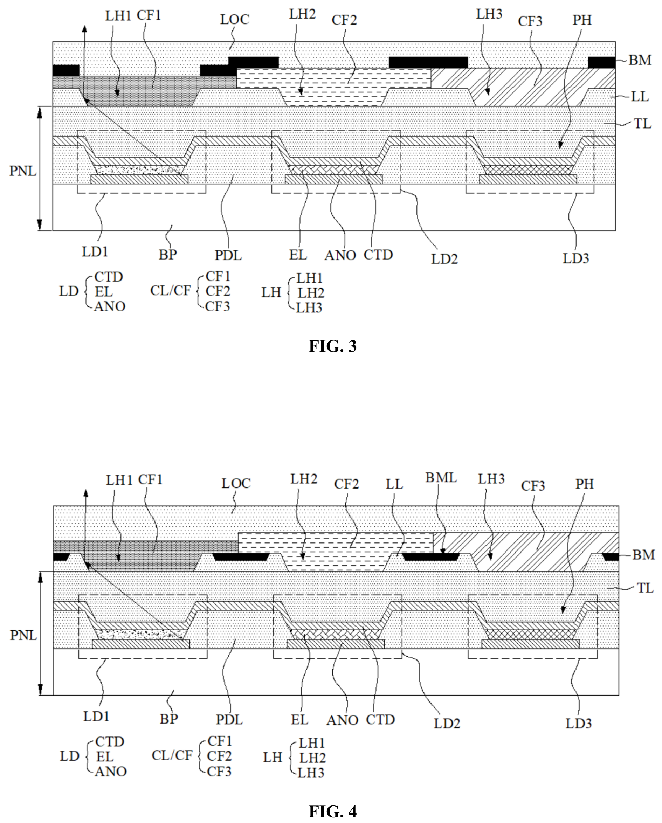

For example, as shown in FIGS. 3-10, the first light-filtering part CF1 has a smaller thickness than the second light-filtering part CF2 and the third light-filtering part CF3. The first light-filtering part CF1 is red, the second light-filtering part CF2 is green, and the third light-filtering part CF3 is blue. The thickness of the first light-filtering part CF1 is not smaller than 2.5 µm, and not greater than 3.5 µm. For example, the thickness of the first light-filtering part CF1 is 2.5 µm, 3 µm, 3.5 µm, etc. The thickness of the second light-filtering part CF2 and the thickness of the third light-filtering part CF3 are both not smaller than 3.4 µm, and not greater than 4 µm. For example, the thickness of the second light-filtering part CF2 and the thickness of the third light-filtering part CF3 may be 3.4 µm, 3.5 µm, 3.8 µm, 4 µm, etc.

In some embodiments of the present disclosure, in order to avoid the light-converging layer LL blocking the light-emitting devices LD and enable the side wall of the light-transmitting hole LH to receive more light, the light-transmitting hole LH may be made not smaller than the light-emitting device LD overlapped with the light-transmitting hole LH, that is, the boundary of the light-emitting device LD is located within the light-emitting range of the light-transmitting hole LH overlapped with the light-emitting device LD, that is, the boundary of the orthographic projection of the light-emitting device LD on the driving backplane BP is located within the boundary of the orthographic projection, on the driving backplane BP, of the light-transmitting hole LH overlapped with the light-emitting device LD. Of course, the boundaries of the two may coincide with each other.

Furthermore, as shown in FIGS. 1 and 2, the boundary of the light-transmitting hole LH may be located outside the boundary of the light-emitting device LD overlapped with the light-transmitting hole LH, that is, the boundary of the orthographic projection of the light-transmitting hole LH on the driving backplane BP is located outside the boundary of the orthographic projection, on the driving backplane BP, of the light-emitting device LD overlapped with the light-transmitting hole LH, causing that a certain distance, in a direction parallel to the display substrate PNL, is present between the boundary of the light-transmitting hole LH and the boundary of the light-emitting device LD overlapped with the light-transmitting hole LH. The distance may be defined as an outward expansion distance of the light-transmitting hole LH.

As shown in FIG. 1, if different light-filtering parts CF have different refractive indices, the total reflection angles at the side walls of the light-transmitting holes LH are also different, causing that different light-filtering parts CF and the light-transmitting holes LH filled by the light-filtering parts CF have different light convergence degrees. In order to improve the uniformity of light convergence degrees, the sizes of the outward expansion distances may be adjusted to make the outward expansion distances of different light-filtering parts CF and the light-transmitting holes LH filled by the light-filtering parts CF different. The greater the refractive index of the light-filtering part CF, the greater the outward expansion distance of the light-transmitting hole LH filled by the light-filtering part CF.

For example, as shown in FIG. 1, in some embodiments, the first light-filtering part CF1 has a greater refractive index than the third light-filtering part CF3, and the third light-filtering part CF3 has a greater refractive index than the second light-filtering part CF2. The outward expansion distance G1 of the first light-transmitting hole LH1 is greater than the outward expansion distance G2 of the third light-transmitting hole LH3, and the outward expansion distance of the third light-transmitting hole LH3 is greater than the outward expansion distance G3 of the second light-transmitting hole LH2.

Furthermore, as shown in FIGS. 1 and 2, the outward expansion distance G1 of the first light-transmitting hole LH1 is not smaller than 2.5 µm, and not greater than 3.5 µm. For example, the outward expansion distance G1 may be 2.5 µm, 3 µm, 3.5 µm, etc.

The outward expansion distance G2 of the second light-transmitting hole LH2 is greater than 0, and not greater than 1 µm. For example, the outward expansion distance G2 is 0.5 µm, 1 µm, etc.

The outward expansion distance G3 of the third light-transmitting hole LH3 is not smaller than 1 µm, and not greater than 2 µm. For example, the outward expansion distance G3 is 1 µm, 1.5 µm, 2 µm, etc.

As shown in FIGS. 1-10, the display panel further includes a light-absorbing layer BM. The light-absorbing layer BM may be arranged at a same side of the display substrate PNL as the light-emitting device LD. For example, the light-absorbing layer BM is arranged at the side of the encapsulation layer TL away from the driving backplane BP. The light-absorbing layer BM may be made of black resin or other materials that can absorb black, as long as the light-absorbing layer BM can absorb visible light. The light-absorbing layer BM may absorb external ambient light and reduce the reflection of the ambient light. Additionally, the portion of the light-absorbing layer BM located between adjacent light-emitting devices LD may also prevent crosstalk.

The light-absorbing layer BM is overlapped with the light-converging layer LL, and is at most partially overlapped with the light-transmitting hole LH. That is to say, in a direction perpendicular to the driving backplane BP, the light-absorbing layer BM does not shield the light-transmitting hole LH or only partially shields the light-transmitting hole LH. Furthermore, in some embodiments, in order to avoid the light-absorbing layer BM limiting the light output range, the orthographic projection of the light-absorbing layer BM on the display substrate PNL may be located within the orthographic projection of the light-converging layer LL on the display substrate PNL, and located outside the orthographic projection of the light-transmitting hole LH on the display substrate PNL, causing that the light-absorbing layer BM and the light-transmitting hole LH are not overlapped with each other at all. Of course, in other embodiments, the light-absorbing layer BM may also be used to reduce the light output range, which achieves anti-peep purposes and other purposes.

In some embodiments of the present disclosure, as shown in FIGS. 1-10, the display panel may further include a light-transmitting planarization layer LOC. The light-transmitting planarization layer LOC may at least cover the light-filtering layer CL for achieving planarization, which facilities provision of other film layers on the light-transmitting planarization layer LOC. Additionally, the light-transmitting planarization layer LOC may be made of resin or other materials that can transmit white light. The light-transmitting planarization layer LOC may have a smaller refractive index than the light-filtering layer CL, that is, the refractive index of the light-transmitting planarization layer LOC is smaller than the refractive index of any light-filtering part CF, avoiding total reflection at the interface where the light-filtering layer CL contacts the light-transmitting planarization layer LOC. Additionally, the light-transmitting planarization layer LOC may be made of the same material as the light-converging layer LL, causing that the light-transmitting planarization layer LOC has a same refractive index as the light-converging layer LL, which facilities simplifying of the process.

The position relationship between the light-absorbing layer BM and the light-converging layer LL may be arranged in various manners. The following provides exemplary illustrations in combination with a plurality of embodiments.

### The First Embodiment

As shown in FIGS. 1 and 2, the light-absorbing layer BM may be arranged on the surface of the encapsulation layer TL away from the display substrate PNL. Of course, other film layers may also be arranged between the light-absorbing layer BM and the encapsulation layer TL. The light-converging layer LL may be stacked on the surface of the light-absorbing layer BM away from the display substrate PNL. The light-absorbing layer BM may be a whole layer structure, and may be provided with through holes in one-to-one-correspondence with the light-transmitting holes LH. The boundary of one through hole may coincide with the boundary of the light-transmitting hole LH corresponding to the through hole, and the through hole can support the light-converging layer LL and avoid shielding the light-transmitting hole LH. Of course, the boundary of the through hole may also be located at the inner side of the boundary of the light-transmitting hole LH, which can reduce the light output angle.

The light-filtering parts CF have the same thickness, and adjacent light-filtering parts CF are connected with each other on the surface of the light-converging layer LL away from the display substrate PNL, causing that the surfaces of the light-filtering parts CF away from the display substrate PNL can be located in the same plane (ignoring process errors and other reasons). The light-transmitting planarization layer LOC may cover the light-filtering layer CL, that is, cover the light-filtering parts CF.

The light-transmitting planarization layer LOC covers the surface of the light-filtering layer CL away from the display substrate PNL.

### The Second Embodiment

As shown in FIG. 3, the light-converging layer LL is arranged on the surface of the encapsulation layer TL away from the display substrate PNL. The light-filtering layer CL has a greater thickness than the light-converging layer LL, and the light-filtering layer CL covers the light-converging layer LL. Adjacent light-filtering parts CF may be connected with each other on the surface of the light-converging layer LL away from the display substrate PNL. If the first light-filtering part CF1 may have a smaller thickness than the second light-filtering part CF2 and the third light-filtering part CF3, the surface of the light-filtering layer CL away from the display substrate PNL may be caused to be recessed at the first light-filtering part CF1.

The light-absorbing layer BM may be arranged on the surface of the light-filtering layer CL away from the display substrate PNL. The light-absorbing layer BM may be a whole layer structure, and may be provided with through holes in one-to-one-correspondence with the light-transmitting holes LH. The boundary of one through hole may be located outside the boundary of the light-transmitting hole LH. Of course, the boundary of one through hole may be located within the boundary of the light-transmitting hole LH. Due to the small thickness of the first light-filtering part CF1, there is a segment difference between the first light-filtering part CF1 and the adjacent light-filtering part CF, which causes the light-absorbing layer BM to have a ramp at the position where the first light-filtering part CF1 and the adjacent light-filtering part CF are connected with each other, that is, the light-absorbing layer BM also has a segment difference. Of course, if the thickness of the first light-filtering part CF1, the thickness of the second light-filtering part CF2, and the thickness of the third light-filtering part CF3 are different from each other, there will be a ramp in the light-absorbing layer BM at adjacent two connections of the light-absorbing layer BM. Of course, for light-filtering parts CF with the same thickness, the light-absorbing layer BM does not have a ramp.

The light-transmitting planarization layer LOC fills the through hole, i.e., covering the region of the light-filtering layer CL exposed by the through hole, and also covering the light-absorbing layer BM, thereby achieving planarization.

### The Third Embodiment

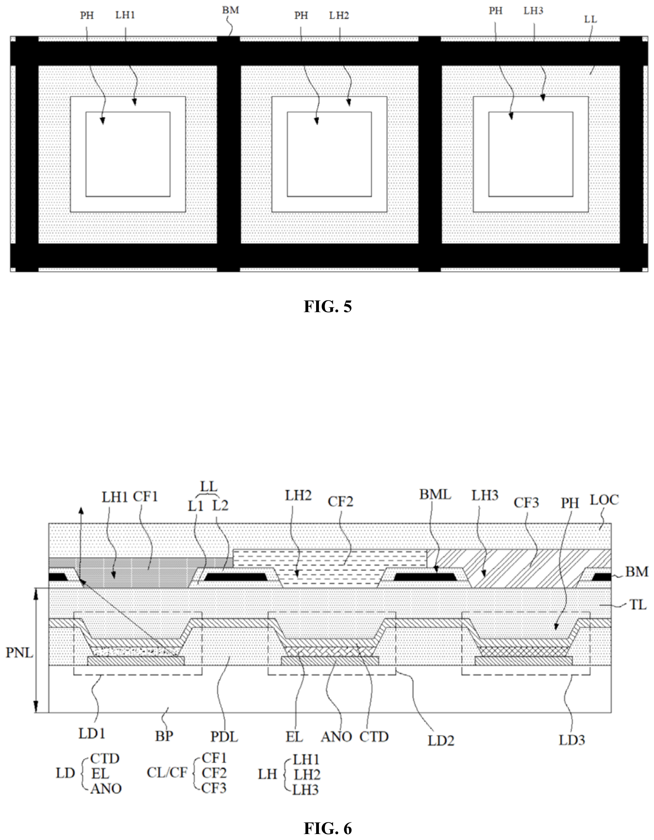

As shown in FIGS. 4 and 5, the light-converging layer LL is arranged on the surface of the encapsulation layer TL away from the display substrate PNL. The light-filtering layer CL has a greater thickness than the light-converging layer LL, and the light-filtering layer CL covers the light-converging layer LL. Adjacent light-filtering parts CF may be connected with each other on the surface of the light-converging layer LL away from the display substrate PNL. If the first light-filtering part CF1 may have a smaller thickness than the second light-filtering part CF2 and the third light-filtering part CF3, the surface of the light-filtering layer CL away from the display substrate PNL may be caused to be recessed at the first light-filtering part CF1.

To avoid process defects such as easy damage due to the occurrence of the segment difference in the light-absorbing layer BM on the surface of the light-filtering layer CL away from the display substrate PNL, a light-absorbing groove BML recessed towards the display substrate PNL may be provided on the surface of the light-converging layer LL away from the display substrate PNL. The depth of the light-absorbing layer BM may be smaller than the thickness of the light-converging layer LL. The light-absorbing layer BM may be filled in the light-absorbing groove BML, enabling that the light-absorbing layer BM is embedded in the light-converging layer LL. As shown in FIGS. 4 and 5, the light-absorbing layer BM may have a same thickness as the light-absorbing groove BML, causing that the surface of the light-absorbing layer BM away from the display substrate PNL is flush with the surface of the light-converging layer LL away from the display substrate PNL, which improves flatness. Of course, the thickness of the light-absorbing layer BM may also be greater or smaller than the depth of the light-absorbing groove BML. The width of the light-absorbing groove BML is smaller than the width of the light-converging layer LL between two light-transmitting holes LH, ensuring that the side wall of the light-transmitting hole LH will not be decreased due to the arrangement of the light-absorbing groove BML, which is beneficial for ensuring the area of region where the total reflection is performed.

The light-filtering layer CL has a greater thickness than the light-converging layer LL, and the light-filtering layer CL covers the light-converging layer LL. Adjacent light-filtering parts CF may be connected with each other on the surface of the light-converging layer LL away from the display substrate PNL. That is to say, the light-filtering layer CL may cover the light-absorbing layer BM, and adjacent light-filtering parts CF may extend to the surface of the light-absorbing layer BM away from the display substrate PNL and are connected with each other.

Furthermore, the number of the light-absorbing grooves BML is more than one. The light-absorbing groove BML may be an annular structure. One light-absorbing groove BML surrounds one light-transmitting hole LH, that is, the orthographic projection of one light-absorbing groove BML on the display substrate PNL surrounds the orthographic projection of one light-transmitting hole LH on the display substrate PNL. Additionally, the light-absorbing grooves BML surrounding adjacent two light-transmitting holes LH may share a partial region, that is to say, the same region of one light-absorbing groove BML may belong to two light-absorbing grooves BML at the same time.

### The Fourth Embodiment

As shown in FIG. 6, the light-converging layer LL is arranged on the surface of the encapsulation layer TL away from the display substrate PNL. The light-filtering layer CL has a greater thickness than the light-converging layer LL, and the light-filtering layer CL covers the light-converging layer LL. Adjacent light-filtering parts CF may be connected with each other on the surface of the light-converging layer LL away from the display substrate PNL. The first light-filtering part CF1 may have a smaller thickness than the second light-filtering part CF2 and the third light-filtering part CF3.

The light-absorbing layer BM may be encapsulated in the light-converging layer LL. For example, the light-converging layer LL may include a first layer L1 and a second layer L2 stacked sequentially in the direction away from the display substrate PNL. The light-absorbing layer BM is arranged on the surface of the first layer L1 away from the display substrate PNL. The boundary of the light-absorbing layer BM is located at the inner side of the boundary of the first layer L1. The second layer L2 covers the light-absorbing layer BM and the first layer L1 not covered by the light-absorbing layer BM, thereby encapsulating the light-absorbing layer BM in the light-converging layer LL.

### The Fifth Embodiment

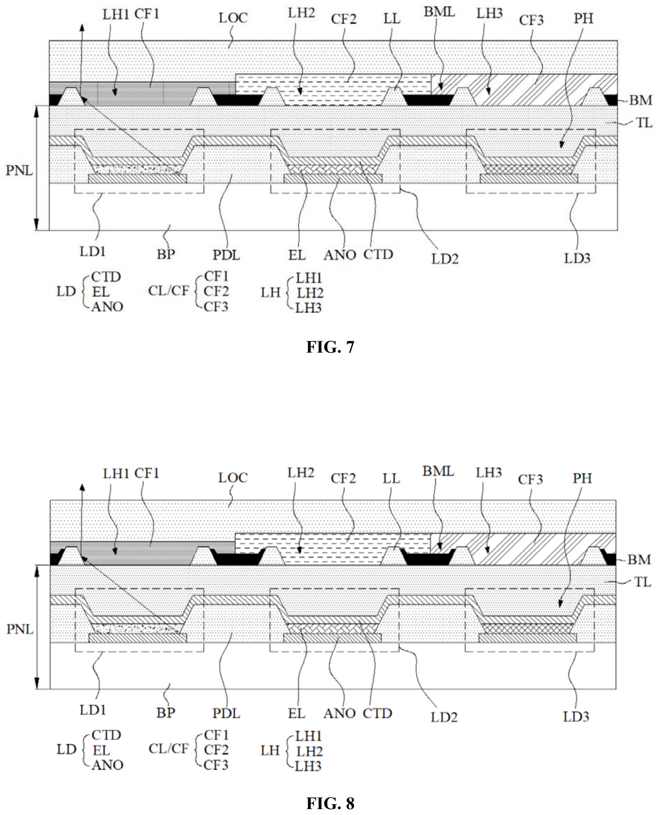

As shown in FIGS. 7-9, the light-converging layer LL may include a plurality of light-converging islands LU arranged at intervals. A certain gap is provided between adjacent two light-converging islands LU. One light-converging island LU is provided with one light-transmitting hole LH. The light-transmitting holes LH and the light-converging islands LU may be in one-to-one correspondence. Of course, one light-converging island LU may be provided with more than one light-transmitting holes LH.

The light-absorbing layer BM and the light-converging layer LL may be arranged on the same surface of the display substrate PNL. For example, both the light-absorbing layer BM and the light-converging layer LL are arranged on the surface of the encapsulation layer TL away from the driving backplane BP. The light-absorbing layer BM is located in the region outside the light-converging island LU, so that the light-converging islands LU may be separated by the light-absorbing layer BM.

The light-absorbing layer BM may have a smaller thickness than the light-converging layer LL. As shown in FIG. 7, the surface of the light-absorbing layer BM away from the display substrate PNL may be a planar surface, causing that the portion of the light-absorbing layer BM located in the light-absorbing groove BML is a planar structure; Alternatively, as shown in FIG. 8, the light-absorbing layer BM may extend along the side wall of the light-absorbing groove BML in the direction away from the display substrate PNL, but not beyond the light-absorbing groove BML, causing that the portion of the light-absorbing groove BML located in the light-absorbing groove BML is a concave structure.

The light-filtering layer CL has a greater thickness than the light-converging layer LL. Adjacent light-filtering parts CF extend through the surface of the light-converging island LU away from the display substrate PNL to the surface of the light-absorbing layer BM away from the display substrate PNL, enabling the light-filtering layer CL to cover the light-converging layer LL and the light-absorbing layer BM. The light-transmitting planarization layer LOC covers the surface of the light-filtering layer CL away from the display substrate PNL.

The inventor found that when the first light-filtering part CF1 has a greater refractive index than the third light-filtering part CF3, and the third light-filtering part CF3 has a greater refractive index than the second light-filtering part CF2, the total reflection angle at the interface between the first light-filtering part CF1 and the first light-transmitting hole LH1 is the smallest, and the total reflection angle at the interface between the second light-filtering part CF2 and the second light-transmitting hole LH2 is the smallest. Because the first light-filtering part CF1 is more prone to total reflection, the light convergence effects of light-filtering parts CF with different refractive indices are inconsistent. Therefore, the second light-filtering part CF2 and the third light-filtering part CF3, as well as the second light-transmitting hole and the third light-transmitting hole LH3 filled by the second light-filtering part CF2 and the third light-filtering part CF3, may be moved in the direction away from the display substrate PNL, causing their distance from the second light-emitting device and the third light-emitting device LD3 to be greater than the distance between the first light-filtering part CF1 and the first light-emitting device LD1, thereby increasing the incident angle of the light emitted by the second light-emitting device and the third light-emitting device LD3 at the interface between the second light-filtering part CF2 and the second light-transmitting hole filled by the second light-filtering part CF2 and at the interface between the third light-filtering part CF3 and the third light-transmitting hole LH3 filled by the third light-filtering part CF3, which facilitates total reflection and makes brightness more uniform. The following is an exemplary explanation.

### The Sixth Embodiment

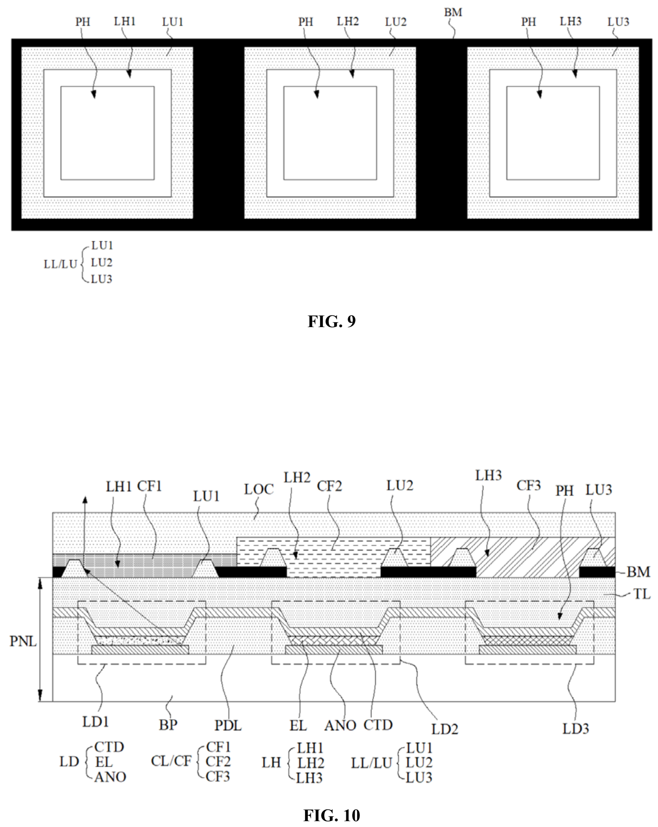

As shown in FIG. 10, referring to the fourth embodiment described above, the light-converging layer LL includes a plurality of light-converging islands LU. A light-converging island LU provided with the first light-transmitting hole LH1 is a first light-converging island LU1. A light-converging island LU provided with the second light-transmitting hole LH2 is a second light-converging island LU2. A light-converging island LU provided with the third light-transmitting hole LH3 is a third light-converging island LU3.

The light-absorbing layer BM and a portion of the light-converging islands LU are arranged on the same surface of the display substrate PNL. For example, the first light-converging island LU1 and the light-absorbing layer BM are arranged on the same surface of the display substrate PNL, and the surface may be the surface of the encapsulation layer TL away from the driving backplane BP. Another portion of the light-converging islands LU may be arranged on the surface of the light-absorbing layer BM away from the display substrate PNL, for example, the second light-converging island LU2 and the third light-converging island LU3 may be arranged on the surface of the light-absorbing layer BM away from the display substrate PNL. That is to say, the light-converging layer LL is at least partially arranged on the surface of the light-absorbing layer BM away from the display substrate PNL.

Due to the presence of the light-absorbing layer BM, the distance between the second light-converging island LU2 and the display substrate PNL, and the distance between the third light-converging island LU3 and the display substrate PNL may be greater than the distance between the first light-converging island LU1 and the display substrate PNL, that is, there is a segment difference between the first light-converging island LU1 and the second light-converging island LU2, and there is also a segment difference between the first light-converging island LU1 and the third light-converging island LU3. That is to say, relative to the first light-converging island LU1 and the first light-filtering part CF1, the second light-filtering part, the third light-filtering part CF3, the second light-converging island, and the third light-converging island LU3 are lifted and moved in the direction away from the display substrate PNL due to the presence of the light-absorbing layer BM. As a result, the light from the second light-filtering part and the third light-filtering part CF3 is more prone to total reflection, which is beneficial for improving the uniformity of total reflection with the first light-filtering part CF1.

The light-filtering layer CL covers the light-converging layer LL and the light-absorbing layer BM. The thickness of the second light-filtering part CF2 and the thickness of the third light-filtering part CF3 may be the same. The thickness of the first light-filtering part CF1 is smaller than the thickness of the second light-filtering part CF2 and the thickness of the third light-filtering part CF3. Adjacent light-filtering parts CF extend through the surface of the light-converging island LU away from the display substrate PNL to the surface of the light-absorbing layer BM away from the display substrate PNL, enabling the light-filtering layer CL to cover the light-converging layer LL and the light-absorbing layer BM. The light-transmitting planarization layer LOC covers the surface of the light-filtering layer CL away from the display substrate PNL.

### The Seventh Embodiment

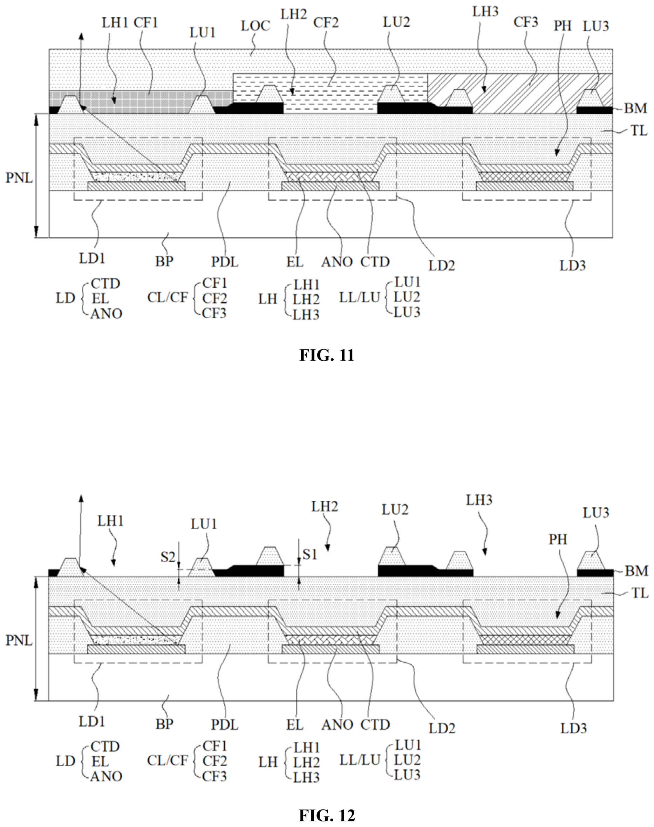

As shown in FIGS. 11 and 12, when the first light-filtering part CF1 has a greater refractive index than the third light-filtering part CF3, and the third light-filtering part CF3 has a greater refractive index than the second light-filtering part CF2, on the basis of the sixth embodiment described above, the light-absorbing layer BM may be made to have a segment difference, causing that the second light-converging island LU2 and the third light light-converging island LU3 also have segment differences. Specifically, the thickness of the region where the light-absorbing layer BM is overlapped with the second light-converging island LU2 may be made greater than the thickness of the region where the light-absorbing layer BM is overlapped with the third light-converging island LU3, causing that the distance between the display substrate PNL, and the second light-converging island LU2 and the second light-filtering part CF2 is greater than the distance between the display substrate PNL, and the third light-converging island LU3 and the third light-filtering part CF3, which makes the second light-filtering part CF2 more prone to total reflection, and achieves that the degree of total reflection of the second light-filtering part CF2 tends to be consistent with that of the third light-filtering part CF3 and the first light-filtering part CF1.

Due to the presence of the segment difference described above, the surface of the light-absorbing layer BM away from the display substrate PNL may have a first surface, a second surface, and a slope surface connecting the first surface and the second surface. The slope surface is smoothly transitioned with the first surface and the second surface. The first surface is located at the side of the second surface away from the display substrate PNL. The second light-converging island LU2 is stacked on the first surface, and the third light-converging island LU3 is stacked on the second surface.

As shown in FIG. 12, the thickness S1 of the region where the light-absorbing layer BM is overlapped with the second light-converging island LU2 is not smaller than 1.5 µm, and not greater than 2 µm. For example, the thickness S1 may be 1.5 µm, 1.8 µm, and 2 µm.

The thickness S2 of the region where the light-absorbing layer BM is overlapped with the third light-converging island LU3 is not smaller than 1 µm, and not greater than 1.5 µm. For example, the thickness S2 may be 1 µm, 1.3 µm, and 1.5 µm.

The light-filtering layer CL covers the light-converging layer LL and the light-absorbing layer BM. The second light-filtering part CF2 may have a same thickness as the third light-filtering part CF3. The first light-filtering part CF1 has a smaller thickness than the second light-filtering part CF2 and the third light-filtering part CF3. Adjacent light-filtering parts CF extend through the surface of the light-converging island LU away from the display substrate PNL to the surface of the light-absorbing layer BM away from the display substrate PNL, enabling the light-filtering layer CL to cover the light-converging layer LL and the light-absorbing layer BM. The light-transmitting planarization layer LOC covers the surface of the light-filtering layer CL away from the display substrate PNL.

In some embodiments of the present disclosure, the display region of the display panel includes a main display region, an opening region located in the main display region, and a transition region located between the opening region and the main display region. The light-emitting device and the pixel circuit may be located in the main display region. The opening region is provided with an opening. The opening may at least pass through the circuit layer of the driving backplane BP. Additionally, the transition region may be provided with an isolation column surrounding the opening region. The side wall of the isolation column is an undercut structure, that is, the side wall of the isolation column is provided with a groove. The undercut structure of the isolation column may cut off the continuous film layer such as the second electrode and the encapsulation layer, and cut off the path of water and oxygen erosion from the opening to the light-emitting device LD. The present disclosure utilizes the characteristic of the light-filtering layer having a greater refractive index than the light-converging layer to achieve total reflection while avoiding the use of materials with excessively high refractive index and excessively high thermal sensitivity coefficient. This can prevent stress pulling of materials with excessively high thermal sensitivity coefficient from causing cracks or damage to the isolation column.

In addition, the peripheral region of the display panel includes a fan out part extending in a direction away from the display region. The fan out part may be a flexible structure, and may be bent towards the backlight side of the display panel. The fan out part may be connected with the motherboard through a flexible circuit board, enabling that the motherboard can transmit signals to the peripheral circuit through the flexible circuit board and the fan out part to drive the light-emitting device to emit light. The light-filtering layer may extend to the fan out region. The present disclosure utilizes the characteristic of the light-filtering layer having a greater refractive index than the light-converging layer to achieve total reflection while avoiding the use of materials with excessively high refractive index and excessively high thermal sensitivity coefficient. This can prevent materials with excessively high thermal sensitivity coefficient from causing cracks or damage during bending.

The present disclosure also provides a display apparatus. The display apparatus may include the display panel in any of the above embodiments. The display panel is a display panel in any of the above embodiments, and its specific structure and beneficial effects may refer to the embodiments of the display panel described above, which will not be repeated herein.

In some embodiments of the present disclosure, the display apparatus may further include a camera device. The camera device may be arranged at the backlight side of the display panel, for example, at the side of the driving backplane away from the light-emitting device. The camera device is overlapped with the opening in the opening region, so that the camera function may be achieved through the opening.

The display apparatus in the present disclosure may be electronic devices with display functions such as mobile phones, tablets, televisions, or other devices, or may be devices with image display functions such as car displays, which will not be listed one by one herein.

After considering the specification and practicing the invention disclosed herein, those skilled in the art will easily come up with other embodiments of the present disclosure. The present application is intended to cover any variations, uses, or adaptive changes of the present disclosure. The variations, uses, or adaptive changes follow the general principles of the present disclosure and include common knowledge or customary technical means in the technical field not disclosed in the present disclosure. The specification and embodiments are only considered exemplary, and the true scope and spirit of the present disclosure are indicated by the appended claims.

## Claims

1. A display panel, comprising:
a display substrate, provided with a plurality of light-emitting devices distributed in an array;
a light-converging layer, arranged at a side of the display substrate, and provided with a plurality of light-transmitting holes, wherein one light-transmitting hole is overlapped with one light-emitting device, and the light-converging layer is made of a light-transmitting material; and
a light-filtering layer, covering the light-converging layer, and comprising a plurality of light-filtering parts, wherein at least some of the light-filtering parts have different colors; one light-filtering part filles one light-transmitting hole; the light-filtering part has a greater refractive index than the light-converging layer; and the light-transmitting hole expands in a direction away from the display substrate.

2. The display panel according to claim 1, wherein the display panel further comprises:
a light-absorbing layer, arranged at a same side of the display substrate as the light-emitting device; wherein the light-absorbing layer is overlapped with the light-converging layer, and is at most partially overlapped with the light-transmitting hole.

3. The display panel according to claim 2, wherein the light-emitting devices comprise a first light-emitting device, a second light-emitting device and a third light-emitting device that have different emission colors from each other;
a light-transmitting hole overlapped with the first light-emitting device is a first light-transmitting hole, and a light-filtering part filling the first light-transmitting hole is a first light-filtering part; a light-transmitting hole overlapped with the second light-emitting device is a second light-transmitting hole, and a light-filtering part filling the second light-transmitting hole is a second light-filtering part; and a light-transmitting hole overlapped with the third light-emitting device is a third light-transmitting hole, and a light-filtering part filling the third light-transmitting hole is a third light-filtering part; and
the first light-filtering part has a smaller thickness than the second light-filtering part and the third light-filtering part.

4. The display panel according to claim 3, wherein the first light-filtering part has a greater refractive index than the third light-filtering part, and the third light-filtering part has a greater refractive index than the second light-filtering part.

5. The display panel according to claim 3, wherein an emission color of the first light-emitting device is red, an emission color of the second light-emitting device is green, and an emission color of the third light-emitting device is blue; and
a color of the first light-filtering part is red, a color of the second light-filtering part is green, and a color of the third light-filtering part is blue.

6. The display panel according to claim 2, wherein an orthographic projection of the light-absorbing layer on the display substrate is located within an orthographic projection of the light-converging layer on the display substrate, and is located outside an orthographic projection of the light-transmitting hole on the display substrate.

7. The display panel according to claim 2, wherein the light-converging layer is at least partially arranged on a surface of the light-absorbing layer away from the display substrate.

8. The display panel according to claim 2, wherein the light-filtering layer has a greater thickness than the light-converging layer; and the light-absorbing layer is arranged on a surface of the light-filtering layer away from the display substrate.

9. The display panel according to claim 2, wherein a light-absorbing groove recessed towards the display substrate is provided on a surface of the light-converging layer away from the display substrate, and the light-absorbing layer is filled in the light-absorbing groove.

10. The display panel according to claim 9, wherein a number of the light-absorbing groove is more than one, and the light-absorbing groove is an annular structure; one light-absorbing groove surrounds one light-transmitting hole; and light-absorbing grooves surrounding two adjacent light-transmitting holes share a partial region.

11. The display panel according to claim 4, wherein the light-converging layer comprises a plurality of light-converging islands arranged at intervals, and one light-converging island is provided with one light-transmitting hole.

12. The display panel according to claim 11, wherein the light-absorbing layer and the light-converging layer are arranged on a same surface of the display substrate, and the light-converging islands are separated by the light-absorbing layer.

13. The display panel according to claim 11, wherein the light-absorbing layer and a portion of the light-converging islands are arranged on a same surface of the display substrate, and a portion of the light-converging islands is arranged on a surface of the light-absorbing layer away from the display substrate.

14. The display panel according to claim 11, wherein a light-converging island provided with the first light-transmitting hole is a first light-converging island; a light-converging island provided with the second light-transmitting hole is a second light-converging island; and a light-converging island provided with the third light-transmitting hole is a third light-converging island; and
the first light-converging island and the light-absorbing layer are arranged on a same surface of the display substrate; and the second light-converging island and the third light-converging island are arranged on a surface of the light-absorbing layer away from the display substrate.

15. The display panel according to claim 14, wherein a thickness of a region where the light-absorbing layer is overlapped with the second light-converging island is greater than a thickness of a region where the light-absorbing layer is overlapped with the third light-converging island.

16. The display panel according to claim 15, wherein the thickness of the region where the light-absorbing layer is overlapped with the second light-converging island is not smaller than 1.5 µm, and not greater than 2 µm; and
the thickness of the region where the light-absorbing layer is overlapped with the third light-converging island is not smaller than 1 µm, and not greater than 1.5 µm.

17. The display panel according to claim 4, wherein a boundary of the light-transmitting hole is located outside a boundary of the light-emitting device overlapped with the light-transmitting hole; and a distance, in a direction parallel to the display substrate, between the boundary of the light-transmitting hole and the boundary of the light-emitting device overlapped with the light-transmitting hole is an outward expansion distance of the light-transmitting hole; and
the first light-transmitting hole has a greater outward expansion distance than the third light-transmitting hole, and the third light-transmitting hole has a greater outward expansion distance than the second light-transmitting hole.

18. The display panel according to claim 17, wherein the outward expansion distance of the first light-transmitting hole is not smaller than 2.5 µm, and not greater than 3.5 µm; an outward expansion distance of the second light-transmitting hole is greater than 0, and not greater than 1 µm; and the outward expansion distance of the third light-transmitting hole is not smaller than 1 µm, and not greater than 2 µm.

19. The display panel according to claim 17, wherein the thickness of the first light-filtering part is not smaller than 2.5 µm, and not greater than 3.5 µm; and a thickness of the second light-filtering part and a thickness of the third light-filtering part are not smaller than 3.4 µm, and not greater than 4 µm.

20. The display panel according to any one of claims 2 to 19, wherein the display substrate comprises:
a driving backplane, wherein the light-emitting device is arranged at a side of the driving backplane;
an encapsulation layer, covering the light-emitting device; wherein the light-converging layer and the light-absorbing layer are arranged at a side of the encapsulation layer away from the driving backplane; and
a light-transmitting planarization layer, covering the light-filtering layer, wherein the light-transmitting planarization layer has a smaller refractive index than the light-filtering layer.

21. A display apparatus, comprising the display panel according to any one of claims 1 to 20.
